# EUROPÄISCHE PATENTSCHRIFT

(11) **EP 0 800 205 B1**
(45) Veröffentlichungstag und Bekanntmachung des Hinweises auf die Patenterteilung: **17.10.2001**
(21) Anmeldenummer: 97104240.3
(22) Anmeldetag: 13.03.1997
(51) Int. Cl.: H01L 21/66, H01L 21/304

(54) **Verfahren zum Vereinzeln von elektronischen Elementen unter Verwendung einer Trägerschicht**
Method of separating electronic components using a carrier film
Méthode de séparation de composants électroniques utilisant une couche support

(30) Priorität: 04.04.1996 DE 19613561
(43) Veröffentlichungstag der Anmeldung: 08.10.1997
(73) Patentinhaber: MICRONAS Semiconductor Holding AG, 8050 Zürich (CH)
(72) Erfinder: Igel, Günter, 79331 Teningen (DE); Mall, Martin, Dr., 79100 Freiburg (DE)
(74) Vertreter: Hornig, Leonore, Dr.

(56) Entgegenhaltungen:
- EP-A- 0 704 895
- DE-A- 3 335 395
- US-A- 3 795 045
- US-A- 4 769 108
- US-A- 5 174 188
- PATENT ABSTRACTS OF JAPAN vol. 006, no. 238 (E-144), 26.November 1982 & JP 57 139935 A (MATSUSHITA DENKI SANGYO KK), 30.August 1982,

## Beschreibung

Die Erfindung betrifft ein Verfahren zum Vereinzeln von in einem Körper verbundenen elektronischen Elementen.

Ein derartiges Verfahren wird beispielsweise in der Halbleitertechnologie verwendet. Dort werden elektronische Elemente in einem Halbleiterwafer erzeugt, wobei die elektronischen Elemente eine wesentlich geringere Dicke als der Halbleiterwafer aufweisen. Daher muß der Halbleiterwafer zunächst auf die gewünschte Enddicke der elektronischen Elemente abgedünnt werden. Dies kann durch mechanisches Abtragen des Materials oder durch Ätzen erfolgen. Die elektronischen Elemente werden dann meist durch Sägen voneinander getrennt. Da nur funktionsfähige elektronische Elemente oder solche mit vorgegebenen elektrischen Eigenschaften ausgewählt und weiterverarbeitet werden sollen, müssen die elektrischen Parameter der elektronischen Elemente getestet werden, bevor die elektronischen Elemente ausgewählt und einer weiteren Vorrichtung zugeführt werden. Diese ist meist eine Bondvorrichtung, in der die elektronischen Elemente auf einen Träger aufgebracht und auf diesem befestigt werden. Das Testen der elektrischen Parameter muß somit an den in dem abgedünnten Wafer miteinander verbundenen elektronischen Elementen oder an den einzelnen elektronischen Elementen erfolgen.

Beide Möglichkeiten sind in der Praxis mit großen Schwierigkeiten verbunden. Einzelne elektronische Elemente sind schwer handhabbar. Zudem ist ihre Rückseite zum Messen nicht zugänglich, da sie auf eine Folie aufgebracht sind. Wenn die elektronischen Elemente gemessen werden, bevor sie mechanisch voneinander getrennt werden, entsteht das Problem, daß die Messungen relativ ungenau sind, da sowohl die mechanischen als auch die elektrischen Eigenschaften der elektronischen Elemente durch den Trennvorgang, der beispielsweise durch Sägen erfolgt, nachträglich noch beeinflußt werden. Zudem muß für die Messung der abgedünnte Wafer mechanisch gehandhabt, z.B. transportiert und fixiert, werden. Dies ist in der Praxis problematisch, da ein abgedünnter Wafer, der eine geringe Dicke aufweist, schwer zu handhaben ist. Da die Anforderungen dahin gehen, elektronische Elemente einer möglichst geringen Dicke zu erzeugen, was insbesondere für Powerelemente erforderlich ist, wird die Handhabbarkeit von elektronischen Elementen im abgedünnten Wafer technisch immer schwieriger. Das Messen der elektronischen Elemente in dem Halbleiterwafer ist daher in vielen Fällen problematisch.

Aus der DE-A-33 35 395 ist ein Verfahren zum Vereinzeln von elektronischen Elementen bekannt, bei dem die von den elektronischen Elementen abgewandte Seite des Körpers abgedünnt wird, die elektronischen Elemente voneinander getrennt werden und elektrische Parameter der elektronischen Elemente nach dem Abdünnen des Körpers getestet werden, und auf die die elektronischen Elemente aufweisende Seite des Körpers eine elektrisch nichtleitende Hilfsschicht aufgebracht wird. Es handelt sich dabei um elektronische Elemente mit Beam-Lead-Struktur, bei denen die Kontakte an den Seiten des jeweiligen elektronischen Elementes flach überstehen. Nach dem Vereinzeln der elektronischen Elemente wird die Hilfsschicht mit den elektronischen Elementen von dem Körper abgezogen, gedehnt und auf einen Träger aufgebracht. Mit Hilfe des Trägers können die elektronischen Elemente sowohl transportiert als auch elektrisch geprüft und weiterverarbeitet werden.

Aus der US-A-4769108 ist ein Verfahren zum Erzeugen von plattenförmigen Halbleiterkörpern aus einem großen Halbleiterkörper heraus offenbart. Der große Halbleiterkörper ist auf einer Trägerplatte befestigt. Der Halbleiterkörper wird in einzelne Halbleiterelemente zerschnitten. Die Zwischenräume werden mit einem Siliconkautschuk gefüllt. In einer Stützplatte werden Löcher durch Bohrungen eingebracht, die an die Struktur der einzelnen Halbleiterelemente angepaßt sind. Die Stützplatte wird mit ihren Bohrungen relativ zu den Halbleiterelementen ausgerichtet und darauf befestigt. Dadurch sind die Halbleiterbauelemente freigelegt. Dann wird die Stützplatte mit den Halbleiterelementen und dem Siliconkautschuk von der Trägerplatte gelöst. Die Halbleiterelemente können dann mittels der Stützplatte weiter bearbeitet werden.

Der Erfindung liegt die Aufgabe zugrunde, ein gattungsgemäßes Verfahren zu schaffen, bei dem die elektronischen Elemente nach dem Abdünnen des Körpers zuverlässiger getestet werden können.

Diese Aufgabe wird durch ein Verfahren zum Vereinzeln von in einem Körper miteinander verbundenen elektronischen Elementen gelöst, bei dem auf die die elektronischen Elemente aufweisende Seite des Körpers eine elektrisch nichtleitende Hilfsschicht aufgebracht wird, in welcher über den elektronischen Elementen jeweils eine Kontaktöffnung, die den/die Kontakt/e des jeweiligen elektronischen Elements freilegt, ausgebildet wird, die von den elektronischen Elementen abgewandte Seite des Körpers abgedünnt wird, die elektronischen Elemente dann elektrisch voneinander getrennt werden, indem in den Zwischenbereichen zwischen je zwei benachbarten elektronischen Elementen auf der der Hilfsschicht abgewandten Seite zur elektrischen Trennung der elektronischen Elemente voneinander jeweils eine sich in Richtung der Hilfsschicht erstreckende Einkerbung ausgebildet wird, danach elektrische Parameter der elektronischen Elemente getestet werden, und die Hilfsschicht eine ausreichende mechanische Stabilität aufweist, so daß die elektronischen Elemente beim Testen der elektrischen Parameter durch die Hilfsschicht miteinander verbunden bleiben.

Durch die erfindungsgemäße Hilfsschicht wird eine größere mechanische Stabilität des abgedünnten Körpers erreicht. Die Kontaktöffnungen in der Hilfsschicht ermöglichen den Zugang zu den Kontakten der elektronischen Elemente, so daß deren elektrische Parameter getestet werden können. Es können dabei über einem elektronischen Element mehrere Kontaktöffnungen ausgebildet werden. Dies kann dann vorteilhaft sein, wenn die elektronischen Elemente eine große Fläche und voneinander entfernt liegende Kontakte haben. Da der Körper aufgrund der Hilfsschicht eine größere mechanische Stabilität erhält, wird das Testen der elektronischen Elemente in dem abgedünnten Zustand des Körpers möglich. Bevorzugterweise wird die Hilfsschicht vor dem Abdünnen des Körpers aufgebracht.

Dadurch daß in den Zwischenbereichen des Körpers zwischen den elektronischen Elementen auf der der Hilfsschicht abgewandten Seite zur elektrischen Trennung der elektronischen Elemente voneinander jeweils eine sich in Richtung der Hilfsschicht erstreckende Einkerbung ausgebildet wird, werden die elektronischen Elemente elektrisch voneinander getrennt. Durch die Hilfsschicht werden sie mechanisch zusammengehalten, so daß ein mechanisches Handhaben der elektronischen Elemente im Verbund möglich ist. Somit ist ein Testen der elektrischen Parameter der einzelnen elektronischen Elemente im Verbund möglich. Dabei werden die elektrischen Parameter nicht durch die anderen elektronischen Elemente, durch den Körper oder durch den Trennvorgang beeinflußt. Das Material und die Dicke der Hilfsschicht können nach den Anforderungen an die mechanische Stabilität der Hilfsschicht, Schutzeigenschaften für die Oberfläche und ähnliches gewählt werden. Die Einkerbungen erstrecken sich im wesentlichen bis zu der Hilfsschicht. Wesentlich ist, daß die Tiefe T der Einkerbungen so groß ist, daß eine ausreichende elektrische Isolation der elektronischen Elemente voneinander erreicht wird. Es kann vorteilhaft sein, wenn ein dünner Bereich des Körpers unterhalb der Hilfsschicht erhalten bleibt. Durch diesen kann beispielsweise die Form der getrennten elektronischen Elemente beeinflußt werden. Es kann auch günstig sein, wenn sich die Einkerbungen bis in die Hilfsschicht hinein erstrecken. Dadurch kann die Dicke der über den Zwischenbereichen verbleibenden Hilfsschicht beeinflußt werden. Die Dicke des in den Zwischenbereichen verbleibenden Materials wird somit durch die Tiefe T der Einkerbungen in dem Körper und durch die Tiefe t der Vertiefungen in der Hilfsschicht bestimmt.

Gemäß einer vorteilhaften Weiterbildung der Erfindung ist in der Hilfsschicht über den Zwischenbereichen zwischen je zwei elektronischen Elementen jeweils eine Vertiefung einer vorgegebenen Tiefe t, die kleiner als die Dicke d der Hilfsschicht ist, ausgebildet. Die Vertiefung kann als Markierung für den Trennvorgang der elektronischen Elemente voneinander benutzt werden.

Das Material der Hilfsschicht wird bei einer vorgegebenen Dicke d und Tiefe t der Vertiefungen so gewählt, daß eine ausreichende mechanische Stabilität erreicht wird, so daß die elektronischen Elemente beim Testen der elektrischen Parameter durch die Hilfsschicht miteinander verbunden bleiben. Die verbleibende Dicke (d-t) an der Stelle der Vertiefungen der Hilfsschicht muß dabei so gewählt werden, daß die elektronischen Elemente mit einer dafür bestimmten Methode getrennt werden können. Ein vorteilhaftes Material für die Hilfsschicht ist ein Polyimid, welches bevorzugterweise photoempfindlich ist. Die Kontaktöffnungen und Vertiefungen in der Hilfsschicht lassen sich durch ein Photolithographieverfahren mit einer geeigneten Maskierungsschicht erzeugen. Dabei ist es günstig, wenn zur Ausbildung der Kontaktöffnungen und der Vertiefungen in der Hilfsschicht eine teildurchlässige Maskierungsschicht verwendet wird. Dann können die Kontaktöffnungen und Vertiefungen gleichzeitig mit nur einer Maskierungsschicht hergestellt werden.

Gemäß einem günstigen Ausführungsbeispiel der Erfindung wird die abgedünnte Seite des Körpers vor dem Ausbilden der Einkerbungen, metallisiert. Dies ist bei allen elektronischen Elementen, die eine metallisierte Rückseite, beispielsweise zum Kontaktieren benötigen, vorteilhaft. Erfolgt die Metallisierung, gemäß einem anderen Ausführungsbeispiel der Erfindung nach dem Ausbilden der Einkerbungen, können die Seitenwände der elektronischen Elemente gleichzeitig mit der Rückseite der elektronischen Elemente metallisiert werden.

Gemäß einem weiteren Ausführungsbeispiel der Erfindung ist in dem abzudünnenden Bereich des Körpers eine Verzögerungsschicht bezüglich des Abdünnvorgangs mit Durchbrechungen in den Zwischenbereichen ausgebildet, und das Abdünnen des Körpers und Ausbilden der Einkerbungen erfolgt gleichzeitig durch Abtragen des Materials des Körpers. Die Verzögerungsschicht hat dabei die Wirkung, daß das Abtragen des Materials in den Zwischenbereichen schneller erfolgt, als in den übrigen Bereichen des Körpers. Hierdurch wird vermieden, daß der abgedünnte Körper zum Ausbilden der Einkerbungen, mechanisch gehandhabt werden muß. Bevorzugterweise erfolgt das Abtragen des Materials durch Ätzen, insbesondere durch Plasmaätzen.

Die Hilfsschicht kann nach dem mechanischen Trennen der elektronischen Elemente, wenn diese nicht mehr gemeinsam gehandhabt werden müssen, entfernt werden, falls die Hilfsschicht bei der Verwendung der elektronischen Elemente nicht benötigt wird oder für die spätere Verwendung ungünstige Eigenschaften aufweist.

Das mechanische Trennen der mit der Hilfsschicht verbundenen elektronischen Elemente kann in der Vorrichtung zum Befestigen der elektronischen Elemente auf einem Träger erfolgen. Die Hilfsschicht wird in dem Bereich des Steges, der die mechanische Verbindung zwischen je zwei elektronischen Elementen darstellt, durchbrochen. Das Durchtrennen des Steges kann mechanisch, durch Wärmebehandlung, beispielsweise mit einem Laser, durch Plasmatrennen o.ä. erfolgen.

Im folgenden wird die Erfindung anhand der Zeichnung näher beschrieben.

Es zeigen:
Fig. 1 einen Ausschnitt durch einen Körper mit elektronischen Elementen nach Aufbringen einer Hilfsschicht,
Fig. 2 den Ausschnitt des Körpers aus Fig. 1 nach dem Abdünnen des Körpers und
Fig. 3 den Ausschnitt des Körpers aus Fig. 1 und Fig. 2 nach Ausbilden von Einkerbungen zwischen den elektronischen Elementen.

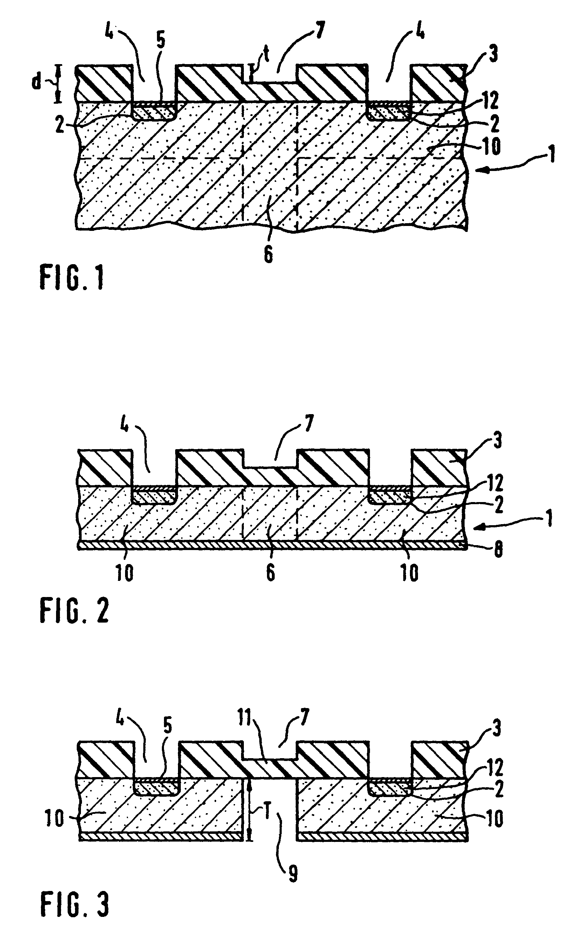

Im folgenden wird das erfindungsgemäße Verfahren beispielhaft für die Anwendung zum Vereinzeln von elektronischen Elementen in einem Halbleiterwafer beschrieben. In Fig. 1 ist ein Ausschnitt aus einem Halbleiterwafer 1 dargestellt, in dem elektronische Elemente 10 miteinander verbunden sind. In der Figur sind zwei der elektronischen Elemente 10 gezeigt. Bei den gezeigten elektronischen Elementen 10 handelt es sich um Dioden, was aber keine Einschränkung für die Erfindung bedeuten soll. Es sind Bereiche 12, die einen zu dem Halbleiterwafer 1 entgegengesetzten Dotierungstyp aufweisen, an der Oberfläche des Halbleiterwafers 1 ausgebildet, so daß an den Grenzflächen jeweils ein pn-Übergang entsteht. Auf dem Halbleiterwafer 1 ist eine Hilfsschicht 3 aufgebracht. In der Hilfsschicht 3 sind Kontaktöffnungen 4, die einen Kontakt 5 des jeweiligen elektronischen Elements 10 freilegen, ausgebildet. Die Kontakte 5 sind in dem gezeigten Ausführungsbeispiel leitende Schichten, typischerweise aus Metall, welche die jeweiligen Bereiche 12 an der Halbleiterwaferoberfläche überdecken. Ferner ist in der Hilfsschicht 3 über einem Zwischenbereich 6 des Halbleiterwafers 1 zwischen den beiden elektronischen Elementen 10 eine Vertiefung mit der Tiefe t ausgebildet. Die Hilfsschicht 3 besteht hier aus einem Polyimid. Eine solche Polyimidschicht ist elektrisch nicht leitend, temperaturstabil und hat eine für das Verfahren günstige mechanische Stabilität.

Danach wird der Halbleiterwafer 1 abgedünnt und auf der abgedünnten Seite mit einer Metallschicht 8 versehen. Der abgedünnte Halbleiterwafer 1 mit der Metallschicht 8 ist in der Fig. 2 gezeigt. Danach werden zwischen je zwei elektronischen Elementen 10 Einkerbungen 9 ausgebildet, wie dies in Fig. 3 dargestellt ist. Hierzu wird der Zwischenbereich 6 des Halbleiterwafers 1 entfernt. Dies kann beispielsweise durch Ätzen erfolgen. Die elektronischen Elemente 10 sind in diesem Zustand elektrisch voneinander getrennt. Mechanisch sind sie noch durch den unterhalb der Vertiefung 7 liegenden Steg 11 der Hilfsschicht 3 miteinander verbunden. Aufgrund der mechanischen Stabilität der Hilfsschicht 3 werden die elektronischen Elemente 10 so zusammengehalten, daß die elektrischen Parameter der elektronischen Elemente 10 über die Kontakte 5 gemessen werden können. Da die elektronischen Elemente 10 elektrisch voneinander isoliert sind, können ihre Parameter, insbesondere ohne den Einfluß der übrigen elektronischen Elemente 10, gemessen werden. Da die Zwischenbereiche 6 zwischen je zwei elektronischen Elementen 10 bereits entfernt sind, werden die elektrischen Eigenschaften der elektronischen Elemente 10 nicht mehr durch einen Trennprozeß verändert. Im gezeigten Ausführungsbeispiel erstrecken sich die Einkerbungen 9 bis zu der Hilfsschicht 3. Die Einkerbungen können sich aber auch bis in die Hilfsschicht 3 hinein erstrecken oder vor der Hilfsschicht 3 enden.

Nachdem die elektrischen Parameter der elektronischen Elemente 10 getestet sind, werden die elektronischen Elemente 10, die weiterverwendet werden sollen, ausgewählt und einer Vorrichtung zur weiteren Verarbeitung zugeführt, welche in der Figur nicht gezeigt ist. In dieser Vorrichtung muß der Steg 11 der Hilfsschicht 3 entfernt werden, so daß die elektronischen Elemente 10 auch mechanisch voneinander getrennt sind. Dies kann entweder in einer separaten Vorrichtung, beispielsweise in einer Trennstation mit einem Laser erfolgen. Dieser Trennvorgang kann auch in der Vorrichtung für den nächsten Verfahrensschritt, üblicherweise in einer Bondvorrichtung, durchgeführt werden. Danach werden die elektronischen Elemente in üblicher Weise, mit dem Fachmann bekannten Verfahren weiterverarbeitet.

## Patentansprüche

1. Verfahren zum Vereinzeln von in einem Körper miteinander verbundenen elektronischen Elementen (10), bei dem
- auf die die elektronischen Elemente (10) aufweisende Seite des Körpers eine elektrisch nichtleitende Hilfsschicht (3) aufgebracht wird, in welcher über den elektronischen Elementen (10) jeweils eine Kontaktöffnung (4), die den/die Kontakt/e (5) des jeweiligen elektronischen Elements (10) freilegt, ausgebildet wird,
- die von den elektronischen Elementen (10) abgewandte Seite des Körpers abgedünnt wird,
- die elektronischen Elemente (10) dann elektrisch voneinander getrennt werden, indem in Zwischenbereichen (6) zwischen je zwei benachbarten elektronischen Elementen (10) auf der der Hilfsschicht (3) abgewandten Seite jeweils eine sich in Richtung der Hilfsschicht (3) erstreckende Einkerbung (9) ausgebildet wird,
- abschließend elektrische Parameter der elektronischen Elemente (10) getestet werden, wobei die Hilfsschicht (3) eine ausreichende mechanische Stabilität aufweist, so daß die elektronischen Elemente (10) beim Testen der elektrischen Parameter durch die Hilfsschicht (3) miteinander verbunden bleiben.

2. Verfahren nach Anspruch 1, **dadurch gekennzeichnet, daß** in der Hilfsschicht (3) über den Zwischenbereichen (6) zwischen je zwei benachbarten elektronischen Elementen (10) jeweils eine Vertiefung (7) einer vorgegebenen Tiefe t, die kleiner als die Dicke d der Hilfsschicht (3) ist, ausgebildet wird.

3. Verfahren nach einem der Ansprüche 1 oder 2, **dadurch gekennzeichnet, daß** das Material der Hilfsschicht (3) aus einem Polyimid besteht.

4. Verfahren nach Anspruch 3 **dadurch gekennzeichnet, daß** das Polyimid photoempfindlich ist.

5. Verfahren nach einem der Ansprüche 1 bis 4, **dadurch gekennzeichnet, daß** zur Ausbildung der Kontaktöffnungen (4) und der Vertiefungen (7) in der Hilfsschicht (3) eine teildurchlässige Maskierungsschicht verwendet wird.

6. Verfahren nach einem der Ansprüche 1 bis 5, **dadurch gekennzeichnet, daß** das Trennen der elektronischen Elemente (10) in einer Vorrichtung zum Befestigen der elektronischen Elemente auf einem Träger erfolgt.

7. Verfahren nach einem der Ansprüche 1 bis 6, **dadurch gekennzeichnet, daß** die abgedünnte Seite des Körpers nach dem Ausbilden der Einkerbungen metallisiert wird.

8. Verfahren nach einem der Ansprüche 1 bis 6, **dadurch gekennzeichnet, daß** die abgedünnte Seite des Körpers vor dem Ausbilden der Einkerbungen metallisiert wird.

9. Verfahren nach einem der Ansprüche 1 bis 7, **dadurch gekennzeichnet, daß** in dem abzudünnenden Bereich des Körpers eine Verzögerungsschicht bezüglich des Abdünnvorgangs mit Durchbrechungen in den Zwischenbereichen ausgebildet ist, und das Abdünnen des Körpers und Ausbilden der Einkerbungen gleichzeitig durch Abtragen des Materials des Körpers erfolgt.

10. Verfahren nach einem der Ansprüche 1 bis 9, **dadurch gekennzeichnet, daß** die Hilfsschicht (3) nach einem mechanischen Trennen der elektronischen Elemente entfernt wird.

## Claims

1. A process for separating electronic devices (10) connected with one another in a body, comprising:
- depositing on the side of the body containing the electronic devices (10) an electrically nonconductive auxiliary layer (3) and forming therein above each of the electronic devices (10) a contact opening (4) to expose the contact(s) (5) of the respective electronic device (10);
- thinning the side of the body remote from the electronic devices (10);
- then electrically isolating the electronic devices (10) from each other by forming on the side remote from the auxiliary layer (3), in intermediate regions (6) between every two adjacent electronic devices (10), respective indentations (9) extending in the direction of the auxiliary layer (3); and
- finally testing electrical parameters of the electronic devices (10), the auxiliary layer (3) having sufficient mechanical stability to ensure that during the testing of the electrical parameters, the electronic devices (10) remain connected with one another by the auxiliary layer (3).

2. A process as claimed in claim 1, **characterized in that** in the auxiliary layer (3), respective depressions (7) of a predetermined depth t less than the thickness d of the auxiliary layer (3) are formed above the intermediate regions (6) between every two adjacent electronic devices (10).

3. A process as claimed in claim 1 or 2, **characterized in that** the material of the auxiliary layer (3) is a polyimide.

4. A process as claimed in claim 3, **characterized in that** the polyimide is photosensitive.

5. A process as claimed in any one of claims 1 to 4, **characterized in that** the contact openings (4) and the depressions (7) in the auxiliary layer (3) are formed using a partially transparent mask layer.

6. A process as claimed in any one of claims 1 to 5, **characterized in that** the separation of the electronic devices (10) takes place in an apparatus for attaching electronic devices to a carrier.

7. A process as claimed in any one of claims 1 to 6, **characterized in that** the thinned side of the body is metallized after the formation of the indentations.

8. A process as claimed in any one of claims 1 to 6, **characterized in that** the thinned side of the body is metallized prior to the formation of the indentations.

9. A process as claimed in any one of claims 1 to 7, **characterized in that** a delay layer for delaying the thinning process and having openings in the intermediate regions is formed in the area of the body to be thinned, and that the thinning of the body and the formation of the indentations are performed simultaneously by removal of the material of the body.

10. A process as claimed in any one of claims 1 to 9, **characterized in that** the auxiliary layer (3) is removed after mechanical separation of the electronic devices.

## Revendications

1. Procédé de séparation de composants électroniques (10) reliés entre eux dans un substrat, dans lequel :
- sur la face du substrat comportant les composants électroniques (10), on dépose une couche auxiliaire (3) non électriquement conductrice dans laquelle on forme, au dessus de chacun des composants électroniques (10), une ouverture de contact (4) qui met à nu le ou les contacts (5) de chacun des composants électroniques (10),
- on amincit la face du substrat opposée aux composants électroniques (10),
- les composants électroniques (10) sont ensuite séparés électriquement les uns des autres, en formant, dans les zones intermédiaires (6) se trouvant entre deux composants électroniques (10) voisins, sur la face opposée à la couche auxiliaire (3), une entaille (9) qui s'étend en direction de la couche auxiliaire (3),
- finalement, on teste des paramètres électriques des composants électroniques (10), la couche auxiliaire (3) présentant une résistance mécanique suffisante de telle sorte que les composants électroniques (10) restent reliés entre eux au moyen de la couche auxiliaire (3) lors du test des paramètres électriques.

2. Procédé selon la revendication 1, **caractérisé en ce que**, dans la couche auxiliaire (3), au dessus des zones intermédiaires (6), entre deux composants électroniques (10) voisins, on forme un évidement (7) ayant une profondeur prédéterminée t qui est plus petite que l'épaisseur d de la couche auxiliaire (3).

3. Procédé selon la revendication 1 ou 2, **caractérisé en ce que** la matière de la couche auxiliaire (3) est constituée d'un polyimide.

4. Procédé selon la revendication 3, **caractérisé en ce que** le polyimide est photosensible.

5. Procédé selon l'une quelconque des revendications 1 à 4, **caractérisé en ce que**, pour la formation des ouvertures de contact (4) et des évidements (7) dans la couche auxiliaire (3), on utilise une couche de masquage transparente.

6. Procédé selon l'une quelconque des revendications 1 à 5, **caractérisé en ce que** la séparation des composants électroniques (10) est réalisée dans un dispositif pour la fixation des composants électroniques (10) sur un support.

7. Procédé selon l'une quelconque des revendications 1 à 6, **caractérisé en ce que** la face amincie du substrat est métallisée après la formation des entailles (9).

8. Procédé selon l'une quelconque des revendications 1 à 6, **caractérisé en ce que** la face amincie du substrat est métallisée avant la formation des entailles (9).

9. Procédé selon l'une quelconque des revendications 1 à 7, **caractérisé en ce que**, dans la zone du substrat qui doit être amincie, on forme une couche de recouvrement concernant le processus d'amincissement avec des découpes dans les zones intermédiaires et **en ce que** l'amincissement du substrat et la formation des entailles (9) sont réalisés en même temps par enlèvement de la matière du substrat.

10. Procédé selon l'une quelconque des revendications 1 à 9, **caractérisé en ce que** la couche auxiliaire (3) est enlevée après une séparation mécanique des composants électroniques.
